(19) Europäisches Patentamt
European Patent Office
Office européen des brevets

(11) **EP 1 594 142 A1**

(12) **EUROPEAN PATENT APPLICATION**
published in accordance with Art. 158(3) EPC

(43) Date of publication:
**09.11.2005 Bulletin 2005/45**

(51) Int Cl.7: **H01B 3/12**, H01B 19/00,
H01L 21/316, H01L 27/10,
C23C 14/06, C01G 35/00

(21) Application number: **04707661.7**

(22) Date of filing: **03.02.2004**

(86) International application number:
**PCT/JP2004/001061**

(87) International publication number:
**WO 2004/070736 (19.08.2004 Gazette 2004/34)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **05.02.2003 JP 2003028256**

(71) Applicants:
• **TOKYO ELECTRON LIMITED**
**Minato-ku, Tokyo 107-8481 (JP)**
• **OHMI, Tadahiro**
**Sendai-shi, Miyagi-ken 980-0813 (JP)**

(72) Inventors:
• **OHMI, Tadahiro**
**Sendai-shi Miyagi 980-0813 (JP)**
• **TAKAHASHI, Ichiro**
**Sendai-shi, Miyagi 982-0802 (JP)**
• **YAMADA, Atsuhiko**
**Sendai-shi, Miyagi 981-1105 (JP)**
• **SAKURAI, Hiroyuki**
**Sendai-shi, Miyagi 981-0966 (JP)**

(74) Representative: **Goddar, Heinz J.**
**FORRESTER & BOEHMERT**
**Pettenkoferstrasse 20-22**
**80336 München (DE)**

(54) **FERROELECTRIC FILM, SEMICONDUCTOR DEVICE, FERROELECTRIC FILM MANUFACTURING METHOD, AND FERROELECTRIC FILM MANUFACTURING APPARATUS**

(57)     An object of the present invention is, while decreasing a relative dielectric constant of a ferroelectric film of $Sr_2(Ta_{1-x}Nb_x)O_7$ ($0 \leq x \leq 1$), to increase an coercive electric field thereof.

The present invention is a ferroelectric film manufacturing method, which includes a film forming step of, in a processing chamber at least an inner surface around a target of which is formed of the same component material as the target, forming a ferroelectric film by colliding ions in plasma with the target and depositing target atoms produced by the collision on a base, and a heating step of heating and oxidizing the ferroelectric film.

FIG.1

## Description

Technical Field

The present invention relates to a ferroelectric film, a semiconductor device, a ferroelectric film manufacturing method, and a ferroelectric film manufacturing apparatus.

Background Art

As a nonvolatile semiconductor memory, a ferroelectric memory which makes use of a spontaneous polarization state of a ferroelectric exists. This ferroelectric memory stores two stable electric polarization states caused by addition of an electric field by associating them with "0" and "1". This ferroelectric memory is known for its lower power consumption and higher speed operation than other nonvolatile memories.

The ferroelectric memory includes a ferroelectric film, for example, in a capacitor portion, and, for example, among field-effect transistor (FET) type ferroelectric memories, there are some in which a gate insulating film, a lower conductor film, the ferroelectric film, and an upper conductor film are stacked in order on a channel forming region of a silicon semiconductor substrate (MFMIS-FET), and others in which the gate insulating film, the ferroelectric film, and the upper conductor film are staked in order on the silicon semiconductor substrate (MFIS-FET).

As a film material for the above ferroelectric film, a ferroelectric material such as $Pb_2(Zr_{1-x}Ti_x)$ ($0 \leq x \leq 1$) (hereinafter referred to as "PZT"), $SrBi_2Ta_2O_9$ (hereinafter referred to "SBT"), or the like is conventionally used, but in recent years, attention is given to $Sr_2(Ta_{1-x}Nb_x)O_7$ ($0 \leq x \leq 1$) (hereinafter referred to as "STN") having Sr, Ta, and Nb as its main components which can hold the relative dielectric constant relatively low and is hard to deteriorate.

Incidentally, at present, used as a film forming method of a ferroelectric film of STN is a sol-gel method in which a precursor solution as a ferroelectric material is applied, dried so that organic matter is vaporized, then heated at a high temperature, oxidized, and crystallized (for example, Japanese Patent Application Laid-open No. Hei 10-326872). Since STN is composed of Ta and Nb which have high ionization energy, extremely high energy is necessary for the oxidation of Ta and Nb atoms. The reason why the above sol-gel method is adopted is that an oxygen component is contained in a precursor from the first, and hence relatively small amount of oxidation energy is required.

However, among the ferroelectric films of STN formed by the above sol-gel method and reported at present, one whose relative dielectric constant is 40 and coercive electric field indicating ferroelectricity is 50 kV/cm is the best, and no one which has a better characteristic is realized.

The ferroelectric memory causes the stable polarization states by applying the electric field to and removing the electric field from the ferroelectric film, and to polarize the ferroelectric film in more saved power, it is necessary to reduce the relative dielectric constant of the ferroelectric film. Moreover, to perform the operation such as storage of the ferroelectric memory more stably, it is necessary to increase the coercive electric field of the ferroelectric film. To realize the power saving and stabilization of the operation of the semiconductor memory as just described, the development of the ferroelectric film with a lower relative dielectric constant and a higher coercive electric field becomes an important challenge.

Disclosure of the Invention

The present invention has been developed in view of the above points, and its object is to provide a ferroelectric film of STN with a lower relative dielectric constant and a higher coercive electric field, a semiconductor device including the ferroelectric film, a ferroelectric film manufacturing method, and a ferroelectric film manufacturing apparatus.

To attain the above object, in a ferroelectric film of the present invention, a ferroelectric material having Sr, Ta, and Nb as its main components is used as a film material, and a relative dielectric constant is less than 40 and a coercive electric field exceeds 50 kV/cm.

According to investigation by the inventors, it is found that by forming an inner surface around a target of a processing chamber where sputtering processing is performed of the same material as the target, forming the ferroelectric film on the surface of a base by the sputtering processing in the processing chamber, and thereafter heating and oxidizing the ferroelectric film, the ferroelectric film of STN with a relative dielectric constant less than 40 and a coercive electric field exceeding 50 kV/cm is manufactured. By this ferroelectric film, a ferroelectric memory, for example, whose power consumption is lower and operation is stable can be manufactured.

The ferroelectric film may include a film layer into which an oxygen component is introduced by oxygen radicals. In this case, since the oxygen component is introduced into a portion of the ferroelectric film, a shortage of the oxygen component in the ferroelectric film is eliminated, and the ferroelectric film is fully oxidized. Accordingly, even if a film material having atoms with high ionization energy such as STN is used for the ferroelectric film, the oxidation is fully performed, and characteristics such as the coercive electric field are improved.

The film layer of the ferroelectric film may contain a rare gas component. Further, it is preferable that the rare gas component be krypton (Kr).

In a semiconductor device comprising a ferroelectric film of the present invention, a ferroelectric material having Sr, Ta, and Nb as its main components is used as a film material for the ferroelectric film, and a relative dielectric constant of the ferroelectric film is less than 40 and a coercive electric field thereof exceeds 50 kV/cm.

The ferroelectric film of the semiconductor device may include a film layer into which an oxygen component is introduced by oxygen radicals. The film layer of the ferroelectric film may contain a rare gas component. The rare gas component may be krypton (Kr). A metal oxide may be used as a material for a base of the ferroelectric film of these semiconductor devices.

Further, the semiconductor device may include an upper conductor film and a lower conductor film on both surfaces of the ferroelectric film so that the ferroelectric film is sandwiched therebetween, and a capacitor may be formed by the ferroelectric film, the upper conductor film, and the lower conductor film. Furthermore, the semiconductor device may further include a field-effect transistor to whose gate the capacitor is connected.

A ferroelectric film manufacturing method of the present invention includes: a film forming step of, in a processing chamber at least an inner surface around a target of which is formed of a same component material as the target, forming a ferroelectric film by colliding ions in plasma with the target and depositing target atoms produced by the collision on a base; and a heating step of heating and oxidizing the ferroelectric film.

According to investigation by the inventors, it is found that the ferroelectric film with a lower relative dielectric film and a higher coercive electric field than were previously possible is manufactured by forming the inner surface around the target of the processing chamber of the same component material as the target, performing film formation of the ferroelectric film by the sputtering processing in the processing chamber, and thereafter heating and oxidizing the ferroelectric film as in the present invention. In a film forming method by a sputtering method such as in the present invention, the ions in the plasma sometimes erroneously collide with a vicinity of the target. According to the present invention, since the vicinity of the target is formed of the same material as the target, even if the ions collide with the vicinity of the target, the same target atoms as when the ions collide with the target jump out. As a result, it can be guessed that the high-purity ferroelectric film with no impurity is formed on the base, and that the good-quality ferroelectric film with a low relative dielectric constant and a high coercive electric field is formed.

The film forming step of the ferroelectric film manufacturing method may include: a first film forming step of forming a relatively thin lower ferroelectric film on the base; an oxygen introducing step of thereafter introducing an oxygen component by oxygen radicals produced by the plasma into the lower ferroelectric film; and a second film forming step of thereafter forming a relatively thick upper ferroelectric film on the lower ferroelectric film. In this case, the thin lower ferroelectric film into which the oxygen component is introduced is formed in a lower layer of the ferroelectric film. This lower ferroelectric film functions as a diffusion preventing layer which prevents the oxygen component in the upper ferroelectric film from diffusing to the base side. Accordingly, an outflow of the oxygen component in the ferroelectric film to the base side is eliminated, whereby the ferroelectric film is fully oxidized and the good-quality film with a high coercive electric field is formed.

The heating step of the ferroelectric film manufacturing method may include: a crystallizing step of crystallizing the ferroelectric film; and an oxygen component recovering step of recovering an amount of an oxygen component of the ferroelectric film after an upper film is formed on the ferroelectric film.

In the oxygen component recovering step, the ferroelectric film may be oxidized by oxygen radicals produced by the plasma. In this case, the ferroelectric film is oxidized by stronger oxidizing power by the oxygen radicals, and therefore the amount of the oxygen component of the ferroelectric film can be recovered by heating at a relatively low temperature.

The ferroelectric film manufacturing method may further include a step of heating the ferroelectric film so that a temperature of the ferroelectric film reaches a Curie temperature or higher and then, when the temperature of the ferroelectric film decreases and passes through the Curie temperature, applying an electric field in a predetermined direction to the ferroelectric film. By applying the electric filed to the ferroelectric film at the time of passage through the Curie temperature as just described, polarization axes in the ferroelectric film are oriented in one direction. As a result, the good-quality ferroelectric film with a high coercive electric field is manufactured. Incidentally, the above-described "at the time of passage through the Curie temperature" includes not only a case where the electric field is applied at a point in time when the Curie temperature is reached, but also a case where the electric field is applied before the Curie temperature is reached.

Further, in the ferroelectric film manufacturing method, a ferroelectric material having Sr, Ta, and Nb as its main components may be used as a film material for the ferroelectric film, and at least the inner surface around the target of the processing chamber may be formed of a material having Sr, Ta, and Nb as its main components.

Furthermore, according to another aspect, in a ferroelectric film manufacturing method of the present invention, a temperature of a ferroelectric film is increased so that the temperature of the ferroelectric film reaches a Curie temperature or higher and then, when the temperature of the ferroelectric film decreases and passes through the Curie temperature, an electric field in a predetermined direction is applied to the ferroelectric film.

According to the present invention, by the application of the electric field, polarization axes in the ferroelectric film are oriented in one direction. Consequently, the good-quality ferroelectric film with a higher coercive electric field is formed.

In a ferroelectric film manufacturing apparatus of the present invention, in a processing chamber housing a processing object, a ferroelectric film is formed on the processing object by colliding ions in plasma with a target and depositing target atoms which have jumped out by the collision on the processing object, and at least a vicinity of the target of an inner surface of the processing chamber is formed of a same component material as the target.

According to the present invention, even when the ions erroneously miss the target and collide with the vicinity of the target, the same atoms as from the target jump out of this collision portion. Consequently, without any impurity mixing into the ferroelectric film deposited on the processing object, the high-purity ferroelectric film is formed. According to investigation by the inventors, it is confirmed that by using such a ferroelectric film manufacturing apparatus, the high-quality ferroelectric film with a low relative dielectric constant and a high coercive electric field is formed.

In the ferroelectric film manufacturing apparatus, a protective member made of the same component material as the target may be attached to the vicinity of the target. Further, in the ferroelectric film manufacturing apparatus, a ferroelectric material having Sr, Ta, and Nb as its main components is used as a film material for the ferroelectric film, and the same component material as the target may be a material having Sr, Ta, and Nb as its main components.

Furthermore, according to another aspect, a ferroelectric film manufacturing apparatus of the present invention includes: a heating part for heating a ferroelectric film to a Curie temperature or higher; and an electric field applying part for applying an electric field in a predetermined direction to the ferroelectric film when a temperature of the ferroelectric film which has reached the Curie temperature or higher decreases and passes through the Curie temperature. A ferroelectric material having Sr, Ta, and Nb as its main components may be used as a film material for the ferroelectric film.

Brief Description of the Drawings

FIG. 1 is a longitudinal sectional view of a sputtering unit to carry out embodiments of the present invention;
FIG 2 is a longitudinal sectional view when an annealing unit is viewed from the side;
FIG. 3 is a longitudinal sectional view when the annealing unit is viewed from the front;
FIG 4 is a longitudinal sectional view of a wafer on which a gate insulating film and a lower conductor film are formed;
FIG 5 is a longitudinal sectional view of the wafer on which a ferroelectric film is formed on the lower conductor film in FIG 4;
FIG. 6 is a longitudinal sectional view of the wafer on which an upper conductor film is formed on the ferroelectric film in FIG. 5;
FIG. 7 is a graph showing a hysteresis characteristic of the ferroelectric film manufactured by the sputtering unit in FIG. 1 and the annealing unit in FIG 2;
FIG. 8 is a graph showing a C-E characteristic of the ferroelectric film in FIG 7;
FIG. 9 is a longitudinal sectional view of a plasma processing unit;
FIG 10 is a longitudinal sectional view of the wafer on which a thin lower ferroelectric film is formed;
FIG. 11 is a longitudinal sectional view of the wafer on which oxygen is introduced into the lower dielectric film by oxygen radicals;
FIG. 12 is a longitudinal sectional view of the wafer on which an upper ferroelectric film is formed on the lower dielectric film in FIG. 11;
FIG. 13 is a graph comparing hysteresis characteristics of the ferroelectric film having the lower dielectric film subjected to plasma processing and the ferroelectric film not subjected to the plasma processing;
FIG. 14 is a graph showing C-E characteristics of the ferroelectric films in FIG. 13;
FIG. 15 is a longitudinal sectional view of an annealing unit including an electric field applying part; and
FIG. 16 is a longitudinal sectional view of the wafer showing a state where an electric field is applied to the wafer.

Best Mode for Carrying out the Invention

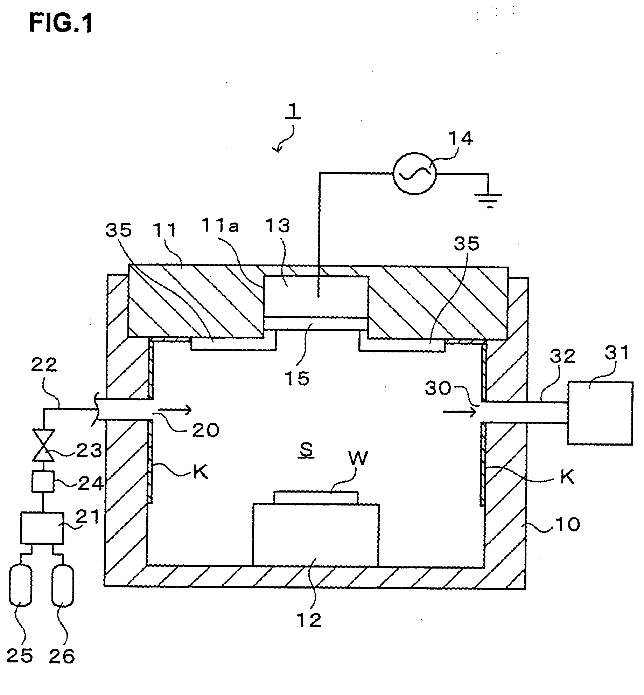

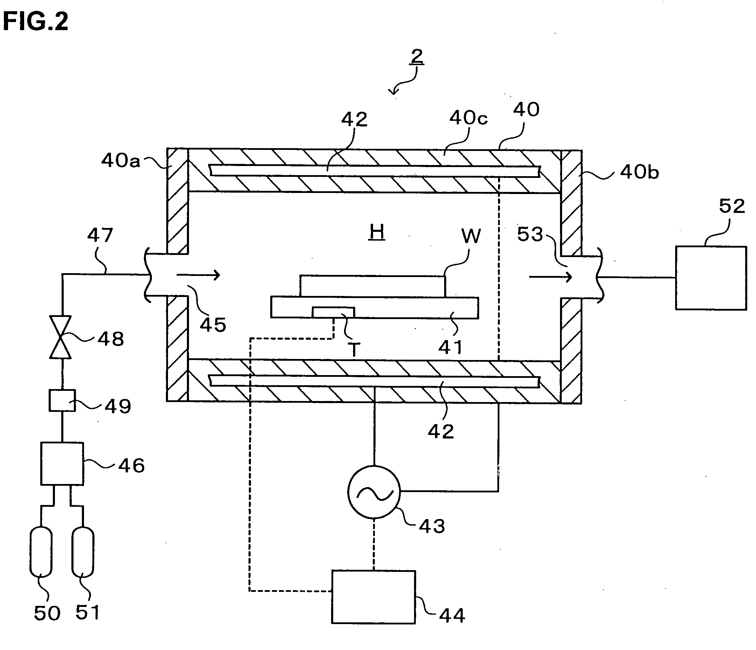

An embodiment of the present invention will be described below. FIG. 1 schematically shows the state of a longitudinal section of a sputtering unit 1 as a ferroelectric film manufacturing apparatus which is used for carry out a ferroelectric film manufacturing method of the present invention. FIG 2 schematically shows the state of a longitudinal section of an annealing unit 2.

The sputtering unit 1 includes a processing container 10, for example, having an open upper portion and a bottomed cylindrical shape, and a lid body 11 with which the upper portion of the processing container 10 can be covered. By covering the upper portion of the processing container 10 with the lid body 11, a processing chamber S is formed. A mounting table 12 on which to mount a substrate, for example, a semiconductor wafer (hereinafter referred to as "a wafer") W as a processing object on which to form the ferroelectric film is provided at a bottom portion of the processing container 10. This mounting table 12 is provided with a suction means not shown, and thereby the mounting table 12 can hold the mounted wafer W by suction.

A recessed portion 11a, for example, is provided in a central portion of a ceiling surface of the processing chamber S facing the mounting table 12, that is, a lower surface of the lid body 11, and an electrode 13 is embedded in the recessed portion 11a. A voltage from a high-frequency source 14 provided outside the processing container 10 can be freely applied to the electrode 13. A target 15 is provided on a lower surface, that is, a surface facing the mounting table 12 of the electrode 13. A material for the target 15 is determined by the type of the ferroelectric film formed on the wafer W, and in this embodiment in which the ferroelectric film of STN ($Sr_2(Ta_{1-x}Nb_x)O_7$ ($0 \leq x \leq 1$)) is formed, $Sr_{2.5}(Ta_{0.7}Nb_{0.3})_2O_7$ having Sr, Ta, Nb as its main components is used as the material for the target 15.

For example, in a side surface of one end of the processing container 10, a processing gas introducing port 20 is provided, and a processing gas supply pipe 22 which leads to a processing gas supply source 21 is connected to the processing gas introducing port 20. A valve 23 and a mass flow controller 24 are provided in the processing gas supply pipe 22, and processing gas at a predetermined pressure can be supplied into the processing chamber S. In this embodiment, respective supply sources 25 and 26 of oxygen gas ($O_2$) and argon (Ar) gas being a rare gas as the processing gas are connected to the processing gas supply source 21. Incidentally, in place of the argon (Ar) gas, another rare gas such as krypton (Kr), xenon (Xe), or the like may be used.

In a side surface of the other end of the processing container 10 facing the above-described processing gas introducing port 20, an exhaust port 30 to exhaust the processing chamber S is provided. An exhaust pipe 32 which leads to an exhauster 31 such as a vacuum pump is connected to the exhaust port 30. The pressure in the processing chamber S, for example, can be reduced to a predetermined pressure by the exhaust from the exhaust port 3 0.

The processing gas supplied into the processing chamber S is turned into plasma by a high-frequency voltage of the electrode 13, and argon ions are produced. By maintaining the potential of the electrode 13 at a negative potential, positively charged argon ions fly toward the target 15 side and collide therewith. By this collision, STN target species which are target atoms jump out of the target 15. A protective member formed of the same component material as the target 15 is attached to a portion with which the argon ions may collide, for example, a vicinity of the target 15 at the lower surface of the lid body 11. Namely, the protective film 35 is formed of a material of $Sr_{2.5}(Ta_{0.7}Nb_{0.3})_2O_7$ which has Sr, Ta, and Nb as its main components. In so doing, even if the argon ions erroneously collide with the vicinity of the target 15, impurities other than the STN deposition species never jump out of the collision portion.

Moreover, when the processing gas is turned into plasma, oxygen radicals are produced in the processing chamber S. The STN deposition species which have jumped out of the target 15 are oxidized by the oxygen radicals and deposited on the surface of the wafer W. A portion exposed to the oxygen radicals in the processing chamber S, for example, a portion of an inner surface of the processing chamber S and higher than the height of the wafer W is coated with a quartz film K. By this quartz film K, the disappearance of the oxygen radicals is inhibited, and the STN deposition species in the processing chamber S are more certainly oxidized.

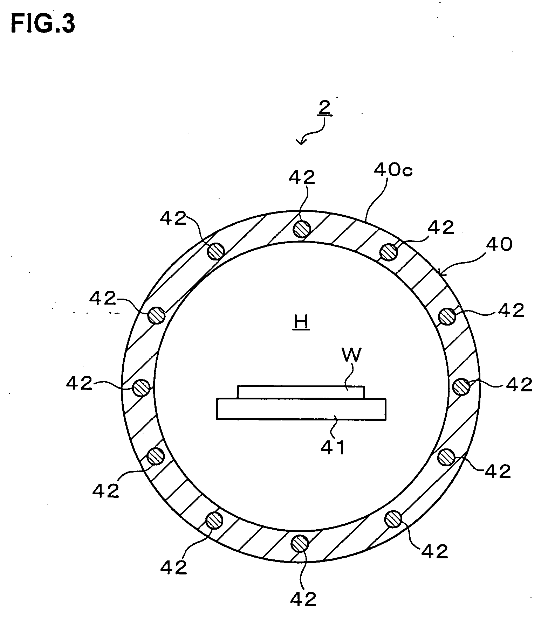

Meanwhile, the annealing unit 2 includes an almost cylindrical casing 40, for example, whose axis is directed horizontally as shown in FIG. 2. Side surface portions 40a and 40b of the casing 40 in an axial direction are closed by flanges, and a closed processing chamber H is formed in the casing 40. In a central portion inside the casing 40, a mounting plate 41 to mount the wafer W on is provided. A cylinder portion 40c which covers a side surface of the casing 40 in a radial direction is formed thick, and heaters 42 are embedded therein. The heaters 42 are evenly embedded over the entire circumference of the cylinder portion 40c as shown in FIG 3 and can heat the wafer W on the mounting plate 41 uniformly from the entire circumferential direction. As shown in FIG. 2, the heaters 42 are connected to a power source 43 placed soutside the casing 40, and generate heat by power feeding from the power source 43. The power source 43 is controlled, for example, by a temperature controller 44, and the temperature controller 44 can control the temperature of the heaters 42 by changing power feeding output of the power source 43. For example, a thermocouple T as a temperature sensor is provided in the mounting plate 41. A result of temperature measurement by the thermocouple T can be outputted to the temperature controller 44, and the temperature controller 44 can regulate the temperature of the heaters 42 based on this temperature measurement result.

A processing gas introducing port 45 is bored in the side surface portion 40a of one end of the casing 40, and a processing gas supply pipe 47 which leads to a processing gas supply source 46 is connected to the processing gas introducing port 45. A valve 48 and a mass flow controller 49 are provided in the processing gas supply pipe 47, and processing gas at a predetermined pressure can be supplied into the processing chamber H. In this embodiment, respective supply sources 50 and 51 of oxygen gas and argon gas as the processing gas are connected to the processing gas supply source 46. Incidentally, in place of the argon gas, nitrogen gas ($N_2$) may be used.

In the side surface portion 40b of the other end of the casing 40 facing the processing gas introducing port 45, an exhaust port 53 leading to an exhauster 52 placed outside the casing 40 to exhaust an atmosphere in the processing chamber H is provided.

The sputtering unit 1 and the annealing unit 2 have structures such as described above, and next, the ferroelectric film manufacturing method according to the embodiment of the present invention will be described with a case where a ferroelectric memory as a semiconductor device is manufactured as an example.

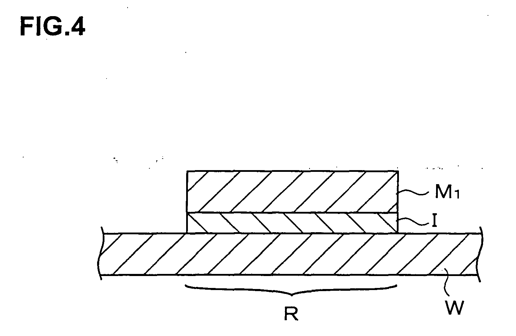

The ferroelectric memory in this embodiment is, for example, a semiconductor memory using a field-effect transistor, and, for example, as shown in FIG. 4, a gate insulating film I as a gate of silicon oxide ($SiO_2$) is formed on a channel region R of the wafer W made of silicon (Si). A lower conductor film $M_1$ made of a metal oxide film, for example, an $IrO_2$ film is formed on the gate insulating film I. This lower conductor film $M_1$ is formed as a base film of the ferroelectric film described later. Incidentally, this lower conductor film $M_1$ may be formed by the same sputtering processing as the ferroelectric film described later.

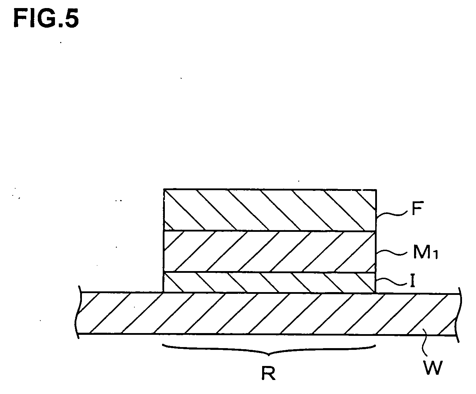

The wafer W on which the lower conductor film $M_1$ is formed is carried to the sputtering unit 1 and held on the mounting table 12 as shown in FIG 1. When the wafer W is held on the mounting table 12, gas in the processing chamber S is exhausted from the exhaust port 30, and the pressure in the processing chamber S is reduced, for example, to approximately 4 Pa. The argon gas and the oxygen gas are supplied from the processing gas supply port 20, and the processing chamber S is filled with the argon gas and the oxygen gas. Subsequently, a negative potential high-frequency voltage is applied to the electrode 13, the gas in the processing chamber S is turned into plasma by this high-frequency voltage, and the argon gas is tuned into argon ions. The argon ions are attracted to the negative potential electrode 13 side and collide with the target 15 at high speed. When the argon ions collide with the target 15, the STN deposition species jump out of the target 15. The STN deposition species which have jumped out are oxidized by the oxygen radials produced by the oxygen gas being turned into plasma, and deposited on the surface of the wafer W. The wafer W is thus subjected to the sputtering processing, and as shown in FIG 5, a ferroelectric film F which uses STN as a film material is formed on the lower conductor film $M_1$.

When the deposition of the STN deposition species is continued for a predetermined time and, for example, the 260-nm ferroelectric film F is formed on the lower conductor film $M_1$, the application of the high-frequency voltage is stopped, and the sputtering processing in the sputtering unit 1 is completed. When the sputtering processing is completed, as shown in FIG 2, the wafer W is carried to the annealing unit 2 and mounted on the mounting plate 41 whose temperature is previously increased, for example, to 900°C by the heaters 42. The oxygen gas and the argon gas are introduced into the processing chamber H from the processing gas supply port 45, and gas in the processing chamber H is exhausted from the exhaust port 53. Thus, an atmospheric current flowing in the axial direction is formed in the processing chamber H, the interior of the processing chamber H continues to be purged, and a mixed gas atmosphere of the oxygen gas and the argon gas is substituted in the processing chamber H. The wafer W mounted on the mounting plate 41 which is maintained at 900°C is heated, and the ferroelectric film F is oxidized and crystallized. When the ferroelectric film F is crystallized, the wafer W is taken out of the annealing unit 2, and annealing processing is completed.

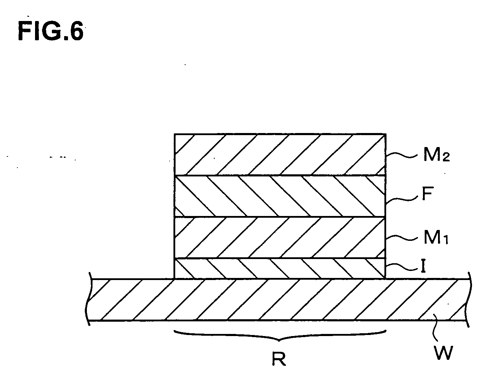

When the annealing processing is completed, an upper conductor film $M_2$ such as shown in FIG. 6 is formed on the ferroelectric film F. This upper ferroelectric film $M_2$ is formed, for example, by the sputtering processing such as described above. When the upper conductor film $M_2$ is formed, the wafer W is carried again to the annealing unit 2 and heated in an oxygen gas atmosphere. Thereby, the surface of the ferroelectric film F is oxidized again, whereby a loss in the amount of oxygen component on the surface of the ferroelectric film F suffered when the upper conductor film $M_2$ is formed is recovered and made up. Thereafter, a photolithography process and the like are performed, and the field-effect transistor type ferroelectric memory is finished.

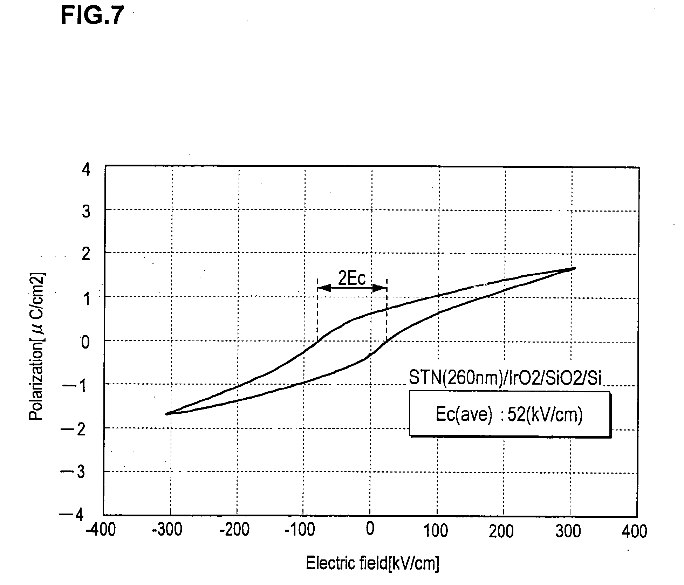

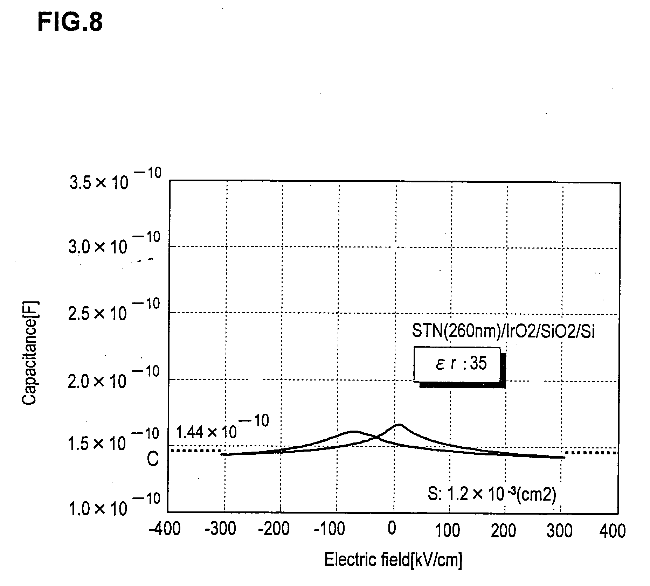

Next, characteristics of the ferroelectric film F of the ferroelectric memory manufactured by the above method will be described using graphs in FIG. 7 and FIG. 8. Processing conditions in the sputtering processing of the above-described ferroelectric film F are as follows.

applied voltage frequency: 13.56 MHz
processing chamber pressure: 4 Pa (30 mTorr)
oxygen partial pressure: 6%

$IrO_2$ is used for the lower conductor film $M_1$ being a base of the ferroelectric film F, and the ferroelectric film F is formed using the sputtering unit 1 in which the protective member 35 is attached to the vicinity of the target 15. FIG 7 shows a hysteresis characteristic of the ferroelectric film F, and a coercive electric field Ec of the ferroelectric film F is 52 kV/cm. FIG. 8 shows a C (Capacitance) - E (Electric field) characteristic of the ferroelectric film F, and on condition that a capacitor area S of the ferroelectric film F is $1.2 \times 10^3$ $cm^2$ and a film thickness df is 260 nm, a capacitance C of the ferroelectric film F is $1.44 \times 10^{-10}$ F. When these numerical values are substituted into Equation 1 to calculate a relative dielectric constant $\varepsilon_f$:

$$\varepsilon_f = (C \cdot df) / (\varepsilon_0 \cdot S), \quad (\varepsilon_0: 8.854 \times 10^{-14} \text{ F/cm})$$

the relative dielectric constant $\varepsilon_f$ of the ferroelectric film F is 35.

Hence, according to the ferroelectric film manufacturing method described above, the unprecedented ferroelectric film F with a relative dielectric constant equal to or less than 40 and a coercive electric field exceeding 50 kV/cm can be formed. According to the observation of the inventor, a reduction in relative dielectric constant and an increase in coercive electric field which are realized by the above-described method result from the attachment of the protective member 35 to the vicinity of the target 15. The protective member 35 can prevent deposition species other than STN from jumping out of the collision portion of the argon ions and being deposited on the wafer W, which can prevent the mixing of impurities into the ferroelectric film F. As a result, the high-purity film is formed, and the relative dielectric constant and the coercive electric field are improved. Moreover, the metal oxide film is used as the base of the ferroelectric film F, which can prevent an outflow of the oxygen component from the ferroelectric film F through the base and a loss of the oxygen component of the ferroelectric film F. Consequently, Ta and Nb atoms in the ferroelectric film F are fully oxidized. In the ferroelectric memory using the ferroelectric film F thus manufactured, it becomes easy for the electric field to be applied to a capacitor portion, for example, composed of the ferroelectric film F and the conductor films $M_1$ and $M_2$ on both sides thereof. As a result, a polarization state of the ferroelectric film F can be created at a lower voltage, and a low power consumption semiconductor memory can be realized. Further, since the coercive electric field is large, the semiconductor memory with a stable polarization state can be realized.

In the ferroelectric film manufacturing method described in the above embodiment, the ferroelectric film F is formed by one round of sputtering processing, but it is also possible to first form a thin lower ferroelectric film, introduce oxygen into the thin lower ferroelectric film by oxygen radicals, and then form a thick upper ferroelectric film. This case will be described as a second embodiment.

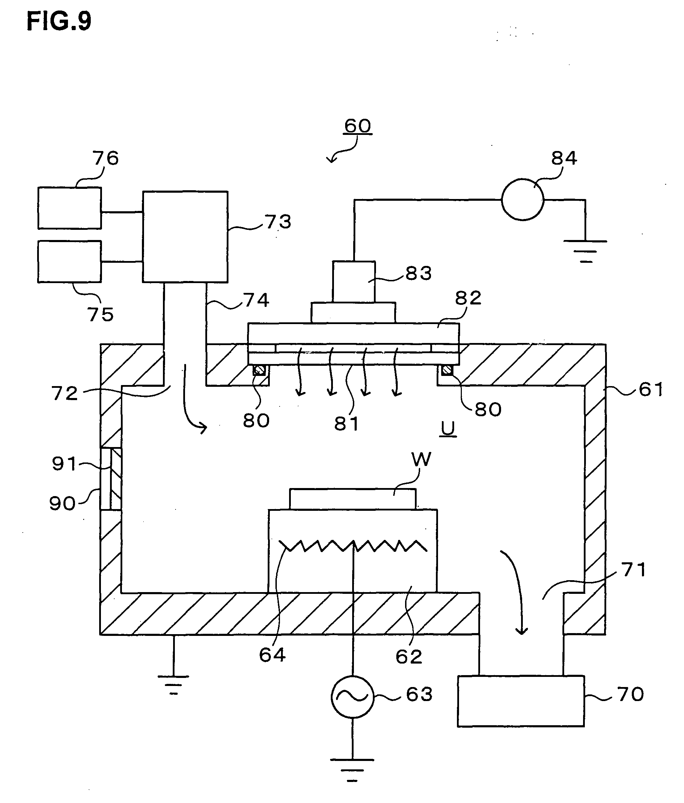

Here, a plasma processing unit to introduce oxygen into the ferroelectric film by the oxygen radicals will be described. FIG. 9 schematically shows the state of a longitudinal section of a plasma processing unit 60, and this plasma processing unit 60 is formed, for example, of an aluminum alloy. The plasma processing unit 60 includes an almost cylindrical processing container 61 having an opening in a ceiling portion. This processing container 61 is grounded. At a bottom portion of the processing container 61, a susceptor 62, for example, on which to mount the wafer W is provided. In this susceptor 62, a heater 64 in the susceptor 62 generates heat by power feeding from an AC power source 63 provided outside the processing container 61, and thereby the wafer W on the susceptor 62 can be heated, for example, to approximately 400°C.

At the bottom portion of the processing container 61, an exhaust port 71, which leads to an exhauster 70 such as a turbo molecular pump, to exhaust gas in the processing container 61 is provided. The exhaust port 71 is provided, for example, close to a side surface portion of the processing container 61. A supply port 72 is provided in the ceiling portion of the processing container 61 on the opposite side of the exhaust port 71 across the susceptor 62. A supply pipe 74 which leads to a processing gas supply source 73 is connected to the supply port 72. In this embodiment, respective supply sources 75 and 76 of oxygen gas and krypton (Kr) gas being a rare gas are connected to the processing gas supply source 73. The gases supplied into the processing container 61 from the supply port 72 pass over the wafer W on the susceptor 62 and exhausted from the exhaust port 71. Incidentally, in place of the krpyton gas, another rare gas may be used.

A dielectric window 81, for example, made of quartz glass is provided in the upper opening of the processing container 61 via a seal member 80 such as an O-ring to ensure hermeticity. By this dielectric window 81, the processing container 61 is closed, and a processing space U is formed in the processing container 61.

An antenna member 82 is provided above the dielectric window 81. A coaxial waveguide 83 is connected to an upper portion of the antenna member 82. The coaxial waveguide 83 is connected to a microwave feeder 84 placed outside the processing container 61. A microwave of 2.45 GHz, for example, generated by the microwave feeder 84 is propagated to the antenna member 82 through the coaxial waveguide 83 and radiated into the processing space U via the dielectric window 81. A carry-in/out port 90 through which to carry the wafer W in/out and a shutter 91 to open/close the carry-in/out port 90 is provided in a side portion of the processing container 61.

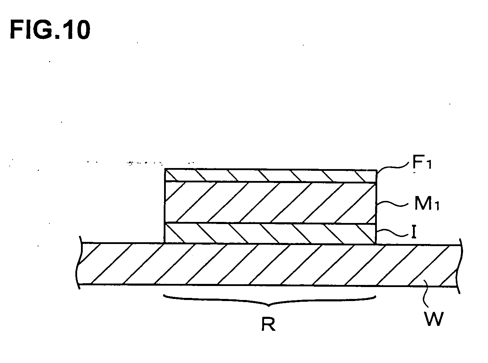

Next, a dielectric film manufacturing method of the second embodiment will be described, and, for example, the wafer W on which the lower conductor film $M_1$ is formed is carried to the sputtering unit 1. In this sputtering unit 1, in the same process as in the above first embodiment, a lower ferroelectric film $F_1$ as a thin film layer of 1 nm or more, for example, approximately 20 nm is formed on the lower conductor film $M_1$, for example, as shown in FIG. 10. When the lower ferroelectric film $F_1$ is formed, the wafer W is carried out of the sputtering unit 1 and carried to the plasma processing unit 60.

In the plasma processing unit 60, the wafer W is carried in from the carry-in/out port 90, and as shown in FIG. 9, mounted on the susceptor 62 which is maintained, for example, at 400°C. Subsequently, a mixed gas of the oxygen gas and the krypton gas is supplied into the processing space U from the supply port 72, and a mixed gas atmosphere is substituted in the processing space U. Gas in the processing space U is exhausted from the exhaust pipe 71, and the pressure in the processing space U is reduced to a predetermined pressure, for example, approximately 133 Pa. Further, a microwave is generated by the microwave feeder 84, and this microwave is propagated to the antenna member 82. Then, the mixed gas in the processing space U is turned into plasma by the microwave, and by oxygen radicals thereby produced in the processing space U, oxygen is introduced into the lower ferroelectric film $F_1$

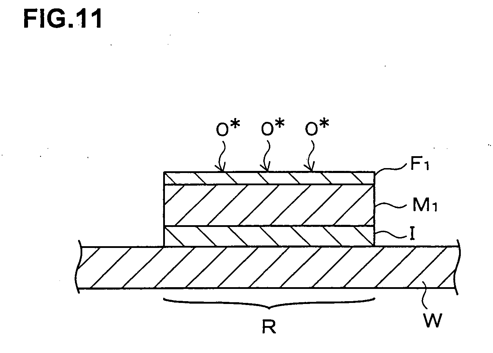

as shown in FIG 11. Incidentally, at this time, a small amount of krypton component is also introduced into the lower ferroelectric film $F_1$.

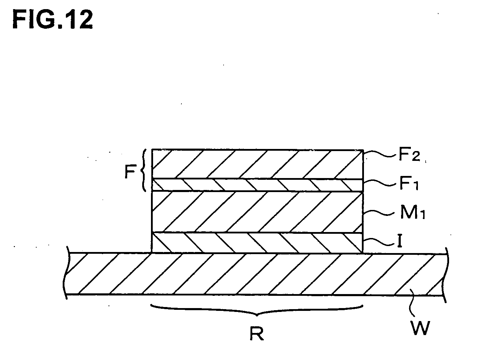

When the oxygen is introduced into the lower ferroelectric film $F_1$ by the oxygen radicals for a predetermined time, the radiation of the microwave from the antenna member 82 is stopped, and the wafer W is carried out of the plasma processing unit 60. The wafer W which has been carried out is carried again to the sputtering unit 1, and as shown in FIG. 12, a thicker upper ferroelectric film $F_2$ of approximately 240 nm is formed on the lower ferroelectric film $F_1$. Thus, the dielectric film F ($F_1 + F_2$) having a two-layer structure is formed on the lower conductor film $M_1$. Thereafter, the wafer W is carried to the annealing unit 2, the dielectric film F is crystallized, then the upper conductor film $M_2$ is formed in the same manner as in the above-described embodiment, and thereafter the wafer W is subjected to the annealing processing for oxygen recovery.

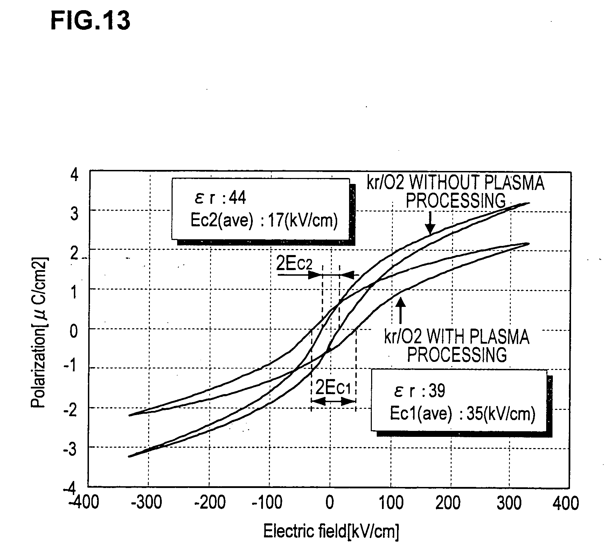

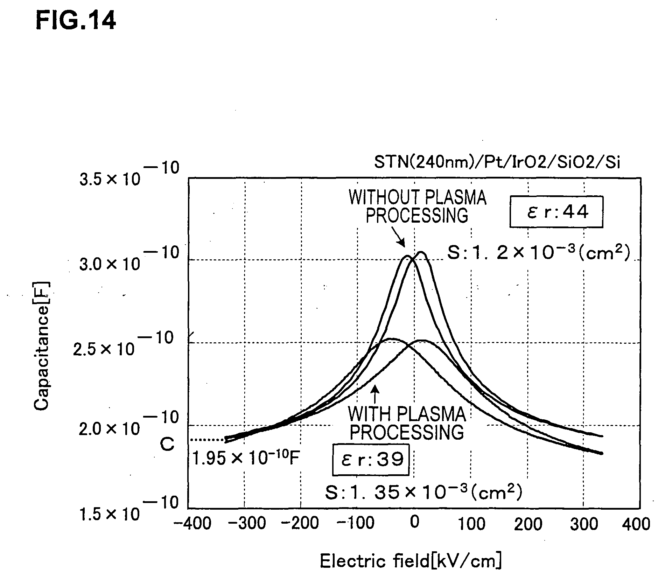

FIG. 13 shows a comparison between hysteresis characteristics of the ferroelectric film F in a case where oxygen is introduced to the lower ferroelectric film $F_1$ by the plasma processing as in the above-described manufacturing method (with the plasma processing) and a case where oxygen is not introduced (without the plasma processing). FIG. 14 shows C-E characteristics in the cases with the plasma processing and without the plasma processing. Incidentally, in experimentation to collect this data, platinum which is a nonoxide is used for the lower conductor film $M_1$ being the base. As shown in FIG. 13, a coercive electric field $Ec_1$ of the ferroelectric film F with the plasma processing is 35 kV/cm, and a coercive electric field $Ec_2$ of the ferroelectric film without the plasma processing is 17 kV/cm. Further, as shown in FIG. 14, in the case with the plasma processing, the capacitance C is $1.95 \times 10^{-10}$ F on condition that the capacitor area S is $1.35 \times 10^{-3}$ cm$^2$ and the film thickness is 240 nm, whereas in the case without the plasma processing, the capacitance C is $1.95 \times 10^{-10}$ F on condition that the capacitor area S is $1.2 \times 10^{-3}$ cm$^2$ and the film thickness is 240 nm. Accordingly, from the above Equation 1, the relative dielectric constant $\varepsilon_f$ of the ferroelectric film F in the case with the plasma processing is 39, whereas the relative dielectric constant $\varepsilon_f$ in the case without the plasma processing is 44.

From the above result, it is found that by forming the lower ferroelectric film $F_1$ and introducing the oxygen to the lower ferroelectric film $F_1$ by the oxygen radicals, the relative dielectric constant of the entire dielectric film F is reduced and the coercive electric field is increased. It is thought that this is because the lower ferroelectric film $F_1$ becomes a blocking wall of the oxygen component by the introduction of the oxygen by the oxygen radicals, which can inhibit the oxygen component in the upper ferroelectric film $F_2$ from flowing out to the lower conductor film $M_1$ and the oxygen component in the entire dielectric film F from being lost.

According to the ferroelectric film manufacturing method of the above second embodiment, the lower ferroelectric film $F_1$ is formed, whereby even when a nonoxide which is apt to absorb the oxygen component is used as a material for the base of the ferroelectric film F, the outflow of the oxygen component is prevented, and thereby the ferroelectric film with a low relative electric constant and a high coercive electric field is formed. Moreover, by forming a thin film at a lower layer of the ferroelectric film F, the ferroelectric film which has a desired plane direction following a plane direction of the lower layer can be formed in an upper layer portion. Therefore, even if the base is amorphous, the good-quality ferroelectric film with a large coercive electric field is formed.

In the annealing processing of replenishing the oxygen component of the ferroelectric film F described in the above embodiments, an electric field may be applied to the ferroelectric film F when the temperature of the wafer W is increased to a Curie temperature of the ferroelectric film F and thereafter the temperature of the ferroelectric film F decreases and passes through the Curie temperature. A ferroelectric film manufacturing method in this case will be described as a third embodiment.

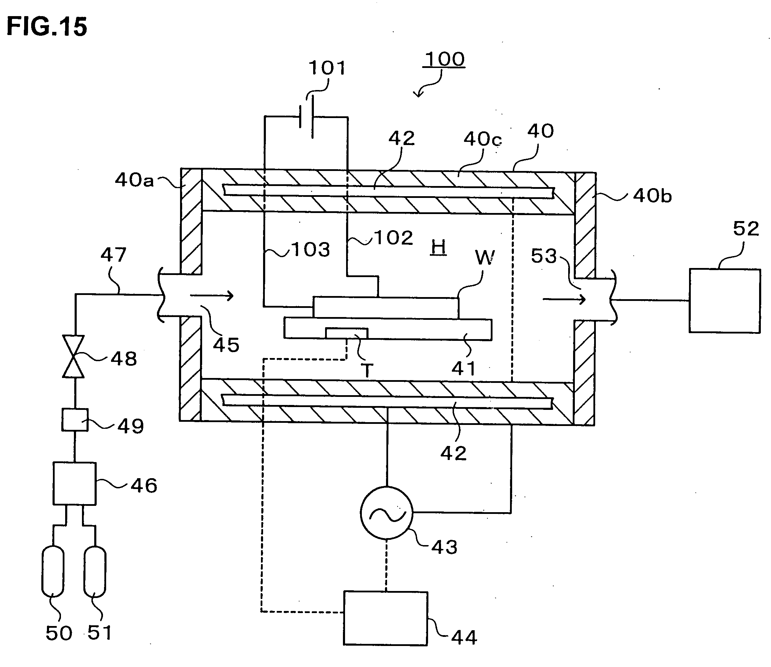

In an annealing unit 100 as a manufacturing unit used in the third embodiment as shown in FIG. 15, in addition to the structure of the above annealing unit 2, for example, a DC power source 101, an anode lead wire 102 of which one end is connected to an anode terminal of the DC power source 101 and the other end is connectable to the wafer W, and a cathode lead wire 103 of which one end is connected to a cathode terminal of the DC power source 101 and the other end is connectable to the wafer W are provided. Incidentally, an electric field applying part in this embodiment is composed of the DC power source 101, the anode lead wire 102, and the cathode lead wire 103, and a heating part is composed of the heaters 42, the AC power source 43, and the temperature controller 44. Moreover, the other members of the annealing unit 100 are the same as those of the annealing unit 2, and a description thereof is omitted.

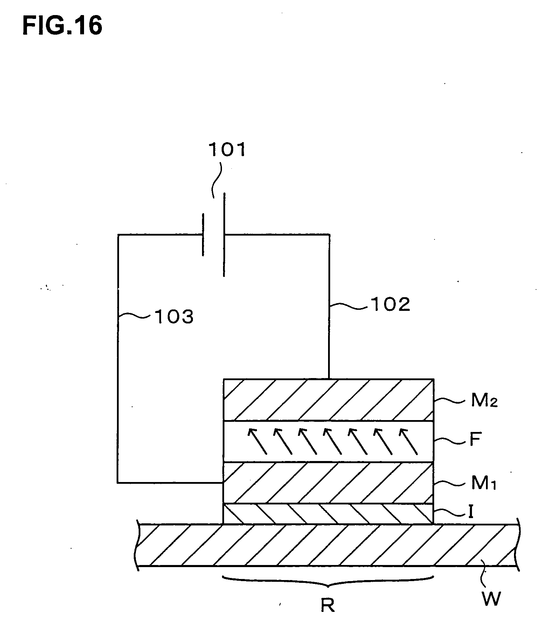

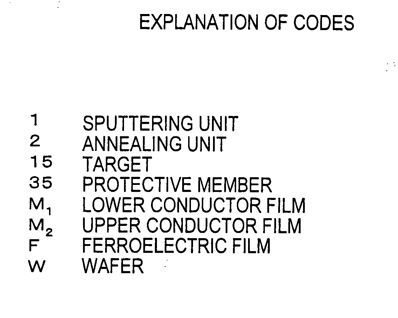

Then, in a manufacturing process of the ferroelectric film in the third embodiment, when the wafer W on which the upper conductor film $M_2$ is formed is carried to the annealing unit 100 and mounted on the mounting plate 41 as shown in FIG. 15, the anode lead wire 102 is connected to the upper conductor film $M_2$ and the cathode lead wire 103 is connected to the lower conductor film $M_1$ as shown in FIG. 16. At this time, the DC power source 101 is OFF, and no electric field is added to the ferroelectric film F. Subsequently, the temperature of the wafer W is increased to a temperature higher than the Curie temperature of the ferroelectric film F, for example, approximately 900°C, by the heaters 42, and the amount of the oxygen component of the ferroelectric film F is recovered. When the amount of the oxygen component is recovered, for example, the heaters 42 are powered off, and the wafer W is gradually cooled. During this cooling, the temperature of the wafer W is continuously measured, for example, by the thermocouple T. Then, when the temperature of the wafer W passes through the Curie temperature of the ferroelectric film F, for example, 600°C, the DC power source 101 is turned on, and a voltage is applied between the upper conductor film $M_2$ and the lower conductor film $M_1$. Consequently, an electric filed is added to the ferroelectric film F, and thereby polarization axes of the ferroelectric film F are oriented in one direction. As a result, remanent polarization of the ferroelectric film F increases, which leads to an increase in coercive electric field.

In the above third embodiment, the process of applying the electric filed to the ferroelectric film F is performed at the time of heating processing for oxygen recovery, but it may be performed, for example, at the time of crystallization heating processing of crystallizing the ferroelectric film F or the sputtering processing of forming the ferroelectric film F.

Incidentally, the processing of applying the electric field to the ferroelectric film such as described in the third embodiment is applicable to a case where instead of the sputtering method described above, for example, a sol-gel method, a CVD method, or the like is used as a method of forming the ferroelectric film, and even if any method is used, improvement in the characteristics of the ferroelectric film is realized.

Further, the annealing processing of recovering oxygen of the ferroelectric film F described in the above embodiments may be performed by oxidizing the oxygen radicals. In this case, for example, the annealing processing of recovering oxygen may be performed using the above-described plasma processing unit 60. For example, the wafer W on which the upper conductor film $M_2$ is formed is carried to the plasma processing unit 60 and mounted on the susceptor 62 maintained at a relatively low temperature of approximately 400°C. Then, the wafer W is heated at 400°C, and the processing gas in the processing space U is turned into plasma by the antenna member 82 and the oxygen radicals are produced. The ferroelectric film F is oxidized by the produced oxygen radicals, and oxygen is recovered. In this case, the oxidation is performed using the oxygen radicals having high oxidation capability, whereby the oxygen component of the ferroelectric film F can be recovered at a low temperature.

The ferroelectric film manufacturing methods described in the above embodiments are not limited to a case where the ferroelectric memory is manufactured and can be also applied to manufacturing of other semiconductor devices using the ferroelectric film. Moreover, although only STN is used as a film material for the ferroelectric film, the present invention is also applicable to a case of a mixed material of STN and PZT, SBT, or the like.

According to the present invention, the relative dielectric constant of the ferroelectric film is reduced, and the coercive electric filed thereof is increased, whereby, for example, using the ferroelectric film, a memory which is power-saving and whose polarization state is stable can be manufactured.

Industrial Applicability

The present invention is useful when concerning a ferroelectric film of $Sr_2(Ta_{1-x}Nb_x)O_7$ ($0 \leq x \leq 1$) which composes a semiconductor device such as a memory, its relative dielectric constant is reduced and coercive electric field is increased.

## Claims

1. A ferroelectric film, wherein
   a ferroelectric material having Sr, Ta, and Nb as its main components is used as a film material, and
   a relative dielectric constant is less than 40 and a coercive electric field exceeds 50 kV/cm.

2. The ferroelectric film as set forth in claim 1, comprising
   a film layer into which an oxygen component is introduced by oxygen radicals.

3. The ferroelectric film as set forth in claim 2, wherein
   said film layer contains a rare gas component.

4. The ferroelectric film as set forth in claim 3, wherein
   the rare gas component is Kr.

5. A semiconductor device comprising a ferroelectric film, wherein
   a ferroelectric material having Sr, Ta, and Nb as its main components is used as a film material for said ferroelectric film, and
   a relative dielectric constant of said ferroelectric film is less than 40 and a coercive electric field thereof exceeds 50 kV/cm.

6. The semiconductor device as set forth in claim 5, wherein
   said ferroelectric film includes a film layer into which an oxygen component is introduced by oxygen radicals.

7. The semiconductor device as set forth in claim 6, wherein
   the film layer contains a rare gas component.

8. The semiconductor device as set forth in claim 7, wherein
   the rare gas component is Kr.

9. The semiconductor device as set forth in claim 5, wherein
a metal oxide is used as a material for a base of said ferroelectric film.

10. The semiconductor device as set forth in claim 5, further comprising
an upper conductor film and a lower conductor film on both surfaces of said ferroelectric film so that said ferroelectric film is sandwiched therebetween, wherein
a capacitor is formed by said ferroelectric film, said upper conductor film, and said lower conductor film.

11. The semiconductor device as set forth in claim 10, further comprising
a field-effect transistor to whose gate the capacitor is connected.

12. A ferroelectric film manufacturing method, comprising:

a film forming step of, in a processing chamber at least an inner surface around a target of which is formed of a same component material as the target, forming a ferroelectric film by colliding ions in plasma with the target and depositing target atoms produced by the collision on a base; and
a heating step of heating and oxidizing the ferroelectric film.

13. The ferroelectric film manufacturing method as set forth in claim 12, wherein
said film forming step comprises:

a first film forming step of forming a relatively thin lower ferroelectric film on the base;
an oxygen introducing step of thereafter introducing an oxygen component by oxygen radicals produced by the plasma into the lower ferroelectric film; and
a second film forming step of thereafter forming a relatively thick upper ferroelectric film on the lower ferroelectric film.

14. The ferroelectric film manufacturing method as set forth in claim 12, wherein
said heating step comprises:

a crystallizing step of crystallizing the ferroelectric film; and
an oxygen component recovering step of recovering an amount of an oxygen component of the ferroelectric film after an upper film is formed on the ferroelectric film.

15. The ferroelectric film manufacturing method as set forth in claim 14, wherein
in said oxygen component recovering step, the ferroelectric film is oxidized by oxygen radicals produced by the plasma.

16. The ferroelectric film manufacturing method as set forth in claim 12, further comprising
a step of heating the ferroelectric film so that a temperature of the ferroelectric film reaches a Curie temperature or higher and then, when the temperature of the ferroelectric film decreases and passes through the Curie temperature, applying an electric field in a predetermined direction to the ferroelectric film.

17. The ferroelectric film manufacturing method as set forth in claim 12, wherein
a ferroelectric material having Sr, Ta, and Nb as its main components is used as a film material for the ferroelectric film, and
at least the inner surface around the target of the processing chamber is formed of a material having Sr, Ta, and Nb as its main components.

18. A ferroelectric film manufacturing method, wherein
a temperature of a ferroelectric film is increased so that the temperature of the ferroelectric film reaches a Curie temperature or higher and then, when the temperature of the ferroelectric film decreases and passes through the Curie temperature, an electric field in a predetermined direction is applied to the ferroelectric film.

19. A ferroelectric film manufacturing apparatus, wherein
in a processing chamber housing a processing object, a ferroelectric film is formed on the processing object by colliding ions in plasma with a target and depositing target atoms which have jumped out by the collision on the processing object, and
at least a vicinity of the target of an inner surface of the processing chamber is formed of a same component material as the target.

20. The ferroelectric film manufacturing apparatus as set forth in claim 19, wherein
a protective member of the same component material as the target is attached to the vicinity of the target.

21. The ferroelectric film manufacturing apparatus as set forth in claim 19, wherein
a ferroelectric material having Sr, Ta, and Nb as its main components is used as a film material for the ferroelectric film, and
the same component material as the target is a material having Sr, Ta, and Nb as its main components.

**22.** A ferroelectric film manufacturing apparatus, comprising:

a heating part for heating a ferroelectric film to a Curie temperature or higher; and
an electric field applying part for applying an electric field in a predetermined direction to the ferroelectric film when a temperature of the ferroelectric film which has reached the Curie temperature or higher decreases and passes through the Curie temperature.

**23.** The ferroelectric film manufacturing apparatus as set forth in claim 22, wherein
a ferroelectric material having Sr, Ta, and Nb as its main components is used as a film material for the ferroelectric film.

**FIG.1**

**FIG.2**

EP 1 594 142 A1

**FIG.3**

FIG.4

FIG.5

## FIG.6

# FIG.7

# FIG.8

**FIG.9**

**FIG.10**

# FIG.11

## FIG.12

# FIG.13

# FIG.14

STN(240nm)/Pt/IrO2/SiO2/Si

WITHOUT PLASMA PROCESSING

$\varepsilon$ r:44

$S:1.2 \times 10^{-3}(cm^2)$

WITH PLASMA PROCESSING

C

$1.95 \times 10^{-10}F$

$\varepsilon$ r:39

$S:1.35 \times 10^{-3}(cm^2)$

Capacitance[F]

$3.5 \times 10^{-10}$
$3.0 \times 10^{-10}$
$2.5 \times 10^{-10}$
$2.0 \times 10^{-10}$
$1.5 \times 10^{-10}$

−400  −300  −200  −100  0  100  200  300  400

Electric field[kV/cm]

**FIG.15**

EP 1 594 142 A1

FIG.16

## EXPLANATION OF CODES

| | |
|---|---|
| 1 | SPUTTERING UNIT |
| 2 | ANNEALING UNIT |
| 15 | TARGET |
| 35 | PROTECTIVE MEMBER |
| $M_1$ | LOWER CONDUCTOR FILM |
| $M_2$ | UPPER CONDUCTOR FILM |
| F | FERROELECTRIC FILM |
| W | WAFER |

<div style="text-align:center">**INTERNATIONAL SEARCH REPORT**</div>

| International application No. |
| --- |
| PCT/JP2004/001061 |

A.  CLASSIFICATION OF SUBJECT MATTER
    Int.Cl$^7$  H01B3/12, H01B19/00, H01L21/316, H01L27/10, C23C14/06,
            C01G35/00

According to International Patent Classification (IPC) or to both national classification and IPC

B.  FIELDS SEARCHED

Minimum documentation searched (classification system followed by classification symbols)
    Int.Cl$^7$  H01B3/12, H01B19/00, H01L21/316, H01L27/10, C23C14/06,
            C01C35/00

| Documentation searched other than minimum documentation to the extent that such documents are included in the fields searched | | | |
| --- | --- | --- | --- |
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)
    WPI/L

C.   DOCUMENTS CONSIDERED TO BE RELEVANT

| Category* | Citation of document, with indication, where appropriate, of the relevant passages | Relevant to claim No. |
| --- | --- | --- |
| Y | EP 940856 A1   (ROHM CO., LTD.),<br>08 September, 1999 (08.09.99),<br>Claims<br>& JP 10-326872 A   (Rohm Co., Ltd.),<br>08 December, 1998 (08.12.98),<br>Claims | 1-11,17,21,23 |
| Y | US 2002/0018904 A1   (Tingkai Li),<br>14 February, 2002 (14.02.02),<br>Par. No. [0070]<br>& JP 2001-7104 A   (Sharp Corp.),<br>12 January, 2001 (12.01.01),<br>Par. No. [0089] | 1-11 |

☒  Further documents are listed in the continuation of Box C.          ☐  See patent family annex.

| | |
| --- | --- |
| *     Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |
| Date of the actual completion of the international search<br>    14 April, 2004 (14.04.04) | Date of mailing of the international search report<br>    27 April, 2004 (27.04.04) |
| Name and mailing address of the ISA/<br>    Japanese Patent Office | Authorized officer |
| Facsimile No. | Telephone No. |

Form PCT/ISA/210 (second sheet) (January 2004)

**INTERNATIONAL SEARCH REPORT**

| International application No. |
|---|
| PCT/JP2004/001061 |

C (Continuation).  DOCUMENTS CONSIDERED TO BE RELEVANT

| Category* | Citation of document, with indication, where appropriate, of the relevant passages | Relevant to claim No. |
|---|---|---|
| X<br>Y | JP 6-158294 A  (Tokimec Inc.),<br>07 June, 1994 (07.06.94),<br>Claims; Fig. 1<br>(Family: none) | 12,19,20<br>2-4,6-8,<br>13-17,21 |
| Y | JP 2002-57155 A. (Fujitsu Ltd.),<br>22 February, 2002 (22.02.02),<br>Claims; Figs. 1 to 5<br>(Family: none) | 13-15 |
| X<br>Y | JP 2001-354497 A  (Matsushita Electric Industrial<br>Co., Ltd.),<br>25 December, 2001 (25.12.01),<br>Claims; Par. No. [0028]<br>(Family: none) | 18,22<br>16,23 |

Form PCT/ISA/210 (continuation of second sheet) (January 2004)

| **INTERNATIONAL SEARCH REPORT** | International application No. |
|---|---|
| | PCT/JP2004/001061 |

---

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III      Observations where unity of invention is lacking (Continuation of item 3 of first sheet)**

This International Searching Authority found multiple inventions in this international application, as follows:
   As stated on the (extra sheet), there must exist a special technical feature so linking a group of inventions of claims as to form a single general inventive concept in order that the group of inventions may satisfy the requirement of unity of invention.   This international application contains three inventions: the invention of claims 1-11; the invention of claims 12-17, 19-21; and the invention of claims 18, 22-23.
      (Continued to extra sheet.)

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**      ☐ The additional search fees were accompanied by the applicant's protest.

☒ No protest accompanied the payment of additional search fees.

---

Form PCT/ISA/210 (continuation of first sheet (2)) (January 2004)

31

| INTERNATIONAL SEARCH REPORT | International application No. |
|---|---|
| | PCT/JP2004/001061 |

Continuation of Box No.III of continuation of first sheet(2)

There must exist a special technical feature so linking a group of inventions of claims as to form a single general inventive concept in order that the group of inventions may satisfy the requirement of unity of invention.

The inventions of claims 1-11 involve a special technical feature, a ferroelectric film made of a ferroelectric material containing Sr, Ta, and Nb as a main component and having a relative dielectric constant of below 40 and a coercive electric field of above 50 kV/cm. Therefore, the inventions are so linked by this special technical feature as to form a single general inventive concept.

The inventions of claims 12-17, 19-21 involve a special technical feature, formation of a ferroelectric film by causing ions in a plasma to collide with a target in a processing chamber where at least a part of the inner surface near the target is made of the same material as the target and thereby depositing target atoms produced by the collision on a base. Therefore, the inventions are so linked by this special technical feature as to form a single general inventive concept.

The inventions of claims 18, 22-23 involve a special technical feature, a process of increasing the temperature of a ferroelectric film to the Curie point or above and applying an electric field in a predetermined direction to the ferroelectric film when the temperature of the ferroelectric film decreases via the Curie point. Therefore, the inventions are so linked by this special technical feature as to form a single general inventive concept.

Consequently, the special technique features of the invention of claims 1-11, the invention of claims 12-17, 19-21, and the invention of claims 18, 22-23 are different from one another.

Therefore, the invention of claims 1-11, the invention of claims 12-17, 19-21, and the invention of claims 18, 22-23 are not so linked as to form a single general inventive concept. Consequently it appears that claims 1-23 do not satisfy the requirement of unity of invention.

Therefore, this international application contains three inventions: the invention of claims 1-11; the invention of claims 12-17, 19-21; and claims 18, 22-23.

Form PCT/ISA/210 (extra sheet) (January 2004)